Europäisches Patentamt

European Patent Office

Office européen des brevets

(19)

(11) Publication number: **0 434 442 A2**

(12) **EUROPEAN PATENT APPLICATION**

(21) Application number: **90314065.5**

(22) Date of filing: **20.12.90**

(51) Int. Cl.5: **G03F 7/023**

(30) Priority: **20.12.89 US 453324**

(43) Date of publication of application:
**26.06.91 Bulletin 91/26**

(84) Designated Contracting States:
**DE FR GB IT NL**

(71) Applicant: **HOECHST CELANESE CORPORATION**
**Route 202-206 North**
**Somerville, N.J. 08876 (US)**

(72) Inventor: **Jain, Sangya**
**891 Ardsley Lane**
**Bridgewater, New Jersey (US)**
Inventor: **Chatterjee, Subhankar**
**42 Overlook Drive**
**Clinto, New Jersey (US)**
Inventor: **DiCarlo, John**
**16 Chandler Drive**
**Coventry, Rhode Island (US)**

(74) Representative: **De Minvielle-Devaux, Ian Benedict Peter et al**
**CARPMAELS & RANSFORD 43, Bloomsbury Square**
**London WC1A 2RA (GB)**

(54) **Positive photoresist composition.**

(57)   A positive photoresist composition consisting essentially of a photosensitive component comprising an ester of 2,3,4,4'-tetrahydroxybenzophenone, having on the average, greater than 3.2 of the hydroxy groups of the 2,3,4,4'-tetrahydroxybenzophenone esterified by 1,2-naphthoquinonediazide-5-sulfonic acid; and a water insoluble, aqueous alkali soluble novolak resin obtained by condensing with formaldehyde a mixture of from about 2.0 to about 5.0 mol percent of 2,4-xylenol, from about 1.5 to about 4.5 mol percent of 2,5-xylenol, from about 1.5 to about 4.0 mol percent of 2,6-xylenol, from about 2.0 to about 5.0 mol percent o-ethylphenol, and the balance m-cresol and p-cresol in a respective mol ratio of from about 0.5 to about 2.0 to 1.

EP 0 434 442 A2

Jouve, 18, rue Saint-Denis, 75001 PARIS

## BACKGROUND OF THE INVENTION

The present invention relates to radiation sensitive positive working photoresist compositions and particularly to compositions containing novolak resins together with naphthoquinone diazide sensitizing agents. It is known to the skilled artisan to produce positive photoresist compositions such as those described in United States Patent Nos. 3,666,473 ; 4,115,128 and 4,173,470. These include water insoluble, aqueous alkali-soluble phenol-formaldehyde novolak resins together with light-sensitive materials, usually a substituted naphthoquinone diazide compound. The resins and sensitizers are dissolved in an organic solvent or mixture of solvents and are applied as a thin film or coating to a substrate suitable for the particular application desired.

The novolak resin component of these photoresist formulations is soluble in aqueous alkaline solutions, but the naphthoquinone sensitizer is not soluble prior to exposure. Upon imagewise exposure of portions of the coated substrate to actinic radiation, the sensitizer is rendered alkali soluble and the exposed areas of the coating therefore become more soluble than the unexposed areas. This difference in solubility rates causes the exposed areas of the photoresist coating to be dissolved when the substrate is immersed in an alkaline developing solution while the unexposed areas are largely unaffected, thus producing a positive relief pattern on the substrate. The exposed and developed substrate is usually thereafter subjected to an etching process. The photoresist coating protects the coated areas of the substrate from the etchant and thus the etchant is only able to etch the uncoated areas of the substrate, which correspond to the areas that were exposed to actinic radiation. Thus, an etched pattern can be created on the substrate which corresponds to the pattern of the mask, stencil, template, etc., that was used to create selective exposure patterns on the coated substrate prior to development. The relief pattern of photoresist on a substrate produced by this method is useful for various applications including the manufacture of miniaturized integrated circuits.

The characteristics of a photoresist composition which are important in commercial practice include its photospeed, high contrast, excellent resolution, thermal stability of the image during processing, wide processing latitude, good line width control, clean development, and low unexposed film loss.

Photoresist contrast is the slope of the linear portion of the curve resulting from the plot of the log of exposure energy vs. normalized film thickness remaining under fixed development conditions. In use, development of an exposed resist coated substrate is continued until the coating on the exposed area is substantially completely dissolved away. Resolution refers to the capability of a resist system to reproduce the smallest equally spaced line pairs and intervening spaces of a mask which is utilized during exposure with a high degree of image edge acuity in the developed exposed spaces. In the manufacture of miniaturized electronic components, a photoresist is required to provide a high degree of resolution for very small line and space widths usually on the order of one micron or less. This capability to reproduce very small dimensions, is extremely important in the production of large scale integrated circuits on silicon chips and similar components. Circuit density on such a chip can only be increased, assuming photolithography techniques are utilized, by increasing the resolution capabilities of the resist. Although negative photoresists, wherein the exposed areas of resist coating become insoluble and the unexposed areas are dissolved away by the developer, have been extensively used for this purpose by the semiconductor industry, positive photoresists have inherently higher resolution and are utilized as replacements for the negative resists.

In photoresist technology, it has normally been desired to increase resist contrast. High contrast positive working resists produce developed images which exhibit high edge acuity, when exposure is performed on typical equipment such as steppers and projection aligners. In most lithographic semiconductor applications, the high edge acuity of developed images is of great importance since it allows for small variations of line width over the wafer's topography. Therefore, it permits good control of etching during anisotropic plasma-etching and is typically associated the good processing latitude.

U.S. Patent 4,719,167 teaches a positive working photoresist employing a novolak resin which is the condensation of m-cresol, p-cresol and 2,5-xylenol with formaldehyde. A resolution of as low as 1.0 microns is taught. The present invention provides an improved photoresist composition which has exceptionally high resolution, on the order of about a 0.7 micron line width compared to prior art photoresists which can resolve down to about a 1.0 micron line width.

## SUMMARY OF THE INVENTION

The invention provides a positive photoresist composition consisting essentially of an admixture of
(a) a photosensitive component comprising an ester of 2,3,4,4'-tetrahydroxybenzophenone, having on the average, from about 60 mol percent to about 100 mol percent of the hydroxy groups of the 2,3,4,4'-tetrahydroxybenzophenone having been esterified by 1,2-naphthoquinonediazide-5-sulfonic acid, said photosensitive component being present in the photoresist composition in an amount sufficient to uniformly photosensitize the photoresist composition ; and

(b) a water insoluble, aqueous alkali soluble novolak resin obtained by condensing with formaldehyde a mixture of from about 2.0 to about 5.0 mol percent of 2,4-xylenol, from about 1.5 to about 4.5 mol percent of 2,5-xylenol, from about 1.5 to about 4.0 mol percent of 2,6-xylenol, from about 2.0 to about 5.0 mol percent o-ethylphenol, and the balance m-cresol and p-cresol in a respective mol ratio of from about 0.5 to about 2.0 to 1 ; said novolak resin being present in the photoresist composition in an amount sufficient to form a substantially uniform photoresist composition.

The invention further provides a photosensitive element which comprises the foregoing admixture coated and dried on a substrate.

The invention also provides a method for producing a photoresist image on a substrate, which comprises coating a substrate with a positive working photosensitive composition which composition comprises in admixture,

(a) a photosensitive component comprising an ester of 2,3,4,4'-tetrahydroxybenzophenone, having on the average, from about 60 mol percent to about 100 mol percent of the hydroxy groups of the 2,3,4,4'-tetrahydroxybenzophenone having been esterified by 1,2-naphthoquinonediazide-5-sulfonic acid, said photosensitive component being present in the photoresist composition in an amount sufficient to uniformly photosensitize the photoresist composition ; and

(b) a water insoluble, aqueous alkali soluble novolak resin obtained by condensing with formaldehyde a mixture of from about 2.0 to about 5.0 mol percent of 2,4-xylenol, from about 1.5 to about 4.5 mol percent of 2,5-xylenol, from about 1.5 to about 4.0 mol percent of 2,6-xylenol, from about 2.0 to about 5.0 mol percent o-ethylphenol, and the balance m-cresol and p-cresol in a respective mol ratio of from about 0.5 to about 2.0 to 1 ; said novolak resin being present in the photoresist composition in an amount sufficient to form a substantially uniform photoresist composition ; and

heat treating said coated substrate until substantially all of said solvent composition is removed ; imagewise exposing said photosensitive composition to actinic radiation ; and removing the imagewise exposed areas of said composition with an aqueous alkaline developer. Optionally one may perform a baking of the substrate either immediately before or after the removing step.

DETAILED DESCRIPTION OF THE PREFERRED EMBODIMENT

In the production of the relief image of the present invention, one coats and dries the foregoing photoresist composition on a suitable substrate.

Novolak resins have been commonly used in the art of photoresist manufacture as exemplified by "Chemistry and Application of Phenolic Rings", Knop A. and Scheib, W. ; Springer Verlag, New York, 1979 in Chapter 4. Similarly, o-quinone diazides are well known to the skilled artisan as demonstrated by "Light Sensitive Systems", Kosar, J. ; John Wiley & Sons, New York, 1965 in Chapter 7.4. However, the instant invention has found that the use of a very particular novolak resin as opposed to those taught in the art in combination with a very particular o-quinone diazide produces a photoresist having exceptional resolution.

The particular novolak resins employed by this invention are water insoluble, aqueous alkali soluble resin obtained by condensing with formaldehyde a mixture of from about 2.0 to about 5.0 mol percent of 2,4-xylenol, from about 1.5 to about 4.5 mol percent of 2,5-xylenol, from about 1.5 to about 4.0 mol percent of 2,6-xylenol, from about 2.0 to about 5.0 mol percent o-ethylphenol, and the balance m-cresol and p-cresol in a respective mol ratio of from about 0.5 to about 2.0 to 1.

More preferably, it is obtained by condensing with formaldehyde a mixture of from about 2.8 to about 4.0 mol percent of 2,4-xylenol, from about 2.3 to about 3.3 mol percent of 2,5-xylenol, from about 2.1 to about 3.0 mol percent of 2,6- xylenol, from about 2.8 to about 4.0 mol percent o-ethylphenol, and the balance m-cresol and p-cresol in a respective mol ratio of from about 0.8 to about 1.5 to 1.

The novolak resin has a preferred molecular weight in the range of from about 6,000 to about 14,000, or more preferably from about 8,000 to about 12,000.

The condensation may be conducted by forming an admixture of the 2,4-xylenol ; 2,5-xylenol ; 2,6-xylenol, o-ethylphenol, m-cresol, and p-cresol and a catalytic amount of oxalic acid, and heating the mixture at from about 90°C to about 110°C with agitation. To the heated mixture is added an aqueous solution of formaldehyde, such as for example a 35% to about 41% aqueous solution. The preferred amount of oxalic acid may range from about 0.5% to about 2.0% based on total cresols. This latter solution may be added to the former dropwise over the course of about 2 hours to about 4 hours. The mixture is allowed to react to completion for about 5 hours to about 8 hours at about 90°C to about 100°C.

The sensitizer which comprises a component of the photoresist composition of the present invention is an ester of 2,3,4,4'-tetrahydroxybenzophenone, having on the average, from about 60 mol percent to about 100 mol percent of the hydroxy groups of the 2,3,4,4'-tetrahydroxybenzophenone having been esterified by 1,2-naphthoquinonediazide-5-sulfonic acid. This compound is not new in and of itself. Its production is described in U.S. Patents 3,106,465, and 4,719,167 which are incorporated herein by reference.

The photoresist composition is formed by blending the ingredients in a suitable solvent composition. In the preferred embodiment, the amount of novolak in the photoresist preferably ranges from 65% to about 99% and more preferably from about 70% to about 95% based on the weight of the solid, i.e. non-solvent resist parts. In the preferred embodiment, the diazide is present in the photoresist in an amount of from about 1% to about 35% or more preferably from about 5% to about 30% based on the weight of the solid resist parts. In manufacturing the resist composition the novolak and diazide are mixed with such solvents as propylene glycol mono-alkyl ether, propylene glycol alkyl ether acetate, butyl acetate, xylene, ethylene glycol monoethyl ether acetate, and most preferably propylene glycol mono-methyl ether acetate, among others.

Other optional ingredients such as colorants, dyes, anti-striation agents, leveling agents, plasticizers, adhesion promoters, speed enhancers, solvents and such surfactants as non-ionic surfactants may be added to the solution of novolak resin, sensitizer and solvent before the solution is coated onto a substrate. Examples of dye additives that may be used together with the photoresist compositions of the present invention include Methyl Violet 2B (C.I. No. 42535), Crystal Violet (C.I. 42555), Malachite Green (C.I. No. 42000), Victoria Blue B (C.I. No. 44045) and Neutral Red (C.I. No. 50040) at one to ten percent weight levels, based on the combined weight of novolak and sensitizer. The dye additives help provide increased resolution by inhibiting back scattering of light off the substrate.

Anti-striation agents may be used at up to a five percent weight level, based on the combined weight of novolak and sensitizer. Plasticizers which may be used include, for example, phosphoric acid tri-(beta-chloroethyl)-ester ; stearic acid ; dicamphor ; polypropylene ; acetal resins ; phenoxy resins ; and alkyl resins at one to ten percent weight levels, based on the combined weight of novolak and sensitizer. The plasticizer additives improve the coating properties of the material and enable the application of a film that is smooth and of uniform thickness to the substrate. Adhesion promoters which may be used include, for example, beta-(3,4-epoxy-cyclohexyl)-ethyltrimethoxysilane ; p-methyl-disilane-methyl methacrylate ; vinyltrichlorosilane ; and gamma-amino-propyl triethoxysilane up to a 4 percent weight level, based on the combined weight of novolak and sensitizer. Development speed enhancers that may be used include, for example, picric acid, nicotinic acid or nitrocinnamic acid by a weight level of up to 20 percent, based on the combined weight of novolak and sensitizer. These enhancers tend to increase the solubility of the photoresist coating in both the exposed and unexposed areas, and thus they are used in applications when speed of development is the overriding consideration even though some degree of contrast may be sacrificed ; i.e., while the exposed areas of the photoresist coating will be dissolved more quickly by the developer, the speed enhancers will also cause a larger loss of photoresist coating from the unexposed areas.

The coating solvents may be present in the overall composition in an amount of up to 95% by weight of the solids in the composition. Solvents, of course are substantially removed after coating of the photoresist solution on a substrate and drying. Non-ionic surfactants that may be used include, for example, nonylphenoxy poly(ethyleneoxy) ethanol ; octylphenoxy ethanol at up to 10% weight levels, based on the combined weight of novolak and sensitizer.

The prepared resist solution, can be applied to a substrate by any conventional method used in the photoresist art, including dipping, spraying, whirling and spin coating. When spin coating, for example, the resist solution can be adjusted with respect to the percentage of solids content in order to provide coating of the desired thickness given the type of spinning equipment utilized and the amount of time allowed for the spinning process. Suitable substrates include silicon, aluminum, polymeric resins, silicon dioxide, doped silicon dioxide, silicon nitride, tantalum, copper, polysilicon, ceramics, aluminum/copper mixtures ; allium arsenide and other such Group III/V compounds. The photoresist coatings produced by the above described procedure are particularly suitable for application to thermally grown silicon/silicon dioxide-coated wafers such as are utilized in the production of microprocessors and other miniaturized integrated circuit components. An aluminum/aluminum oxide wafer can be used as well. The substrate may also comprise various polymeric resins especially transparent polymers such as polyesters. The substrate may have an adhesion promoted layer of a suitable composition such as one containing hexa-alkyl disilazane.

The resist composition solution is then coated onto the substrate, and the substrate is temperature treated at from about 80°C to about 110°C for from about 30 seconds to about 180 seconds on a hot plate or for from about 15 to about 40 minutes in a convection oven. This temperature treatment is selected in order to reduce the concentration of residual solvents in the photoresist while not causing substantial thermal degradation of the photosensitizer. In general one desires to minimize the concentration of solvents and thus this first temperature treatment is conducted until substantially all of the solvents have evaporated and a thin coating of photoresist composition, on the order of a micron in thickness, remains on the substrate. In a preferred embodiment the temperature is conducted at from about 85°C to about 95°C. The treatment is conducted until the rate of change of solvent removal becomes relatively insignificant. The temperature and time selection depends on the resist properties desired by the user as well as equipment used and commercially desired coating times. The coating substrate can then be exposed to actinic radiation, especially ultraviolet radiation, at a wavelength of from about 300 nm to about 450 nm, x-ray, electron beam, ion beam or laser radiation, in any desired pattern, produced by use of suitable masks, negatives, stencils, templates, etc.

The resist is then optionally subjected to a post exposure second baking or heat treatment either before or after development. The eating temperatures may range from about 90°C to about 150°C, more preferably from about 110°C to about 150°C. The heating may be conducted for from about 10 seconds to about 30 minutes, more preferably from about 45 seconds to about 90 seconds on a hot plate or about 10 to about 30 minutes by convection oven.

The exposed resist-coated substrates are developed to remove the imagewise exposed, non-image areas by immersion in an alkaline developing solution. The solution is preferably agitated, for example, by nitrogen burst agitation. The substrates are allowed to remain in the developer until all, or substantially all, of the resist coating has dissolved from the exposed areas. Developers may include aqueous solutions of ammonium or alkali metal hydroxides. One preferred hydroxide is tetramethyl ammonium hydroxide. The most preferred developer is AZ Developer available commercially from the AZ Photoresist Products group of Hoechst Celanese Corporation, Somerville, New Jersey. After removal of the coated wafers from the developing solution, one may conduct an optional post-development heat treatment or bake to increase the coating's adhesion and chemical resistance to etching solutions and other substances. The post-development heat treatment can comprise the oven baking of the coating and substrate below the coating's softening point. The industrial applications, particularly in the manufacture of microcircuitry units on silicon/silicon dioxide-type substrates, the developed substrates may be treated with a buffered, hydrofluoric acid base etching solution. The resist compositions of the present invention are resistant to acid-base etching solutions and provide effective protection for the unexposed resist-coating areas of the substrate.

The following specific examples will provide detailed illustrations of the methods of producing and utilizing compositions of the present invention. These examples are not intended, however, to limit or restrict the scope of the invention in any way and should not be construed as providing invention in any way and should not be construed as providing conditions, parameters or values which must be utilized exclusively in order to practice the present invention.

Example 1

Synthesis of Novolak Resin

A mixture of p-cresol, m-cresol and 2,5-xylenol in a mol ratio of 2.2 : 1.1 : 1 and 8.87 mmol of oxalic acid is heated to 96°C under agitation. To the heated mixture, an aqueous 37% formaldehyde solution is added dropwise over a period of one hour. The mixture is allowed to react for 5 hours at 96-100°C

After completion of the reaction, the mixture is cooled to room temperature and then the pressure is reduced to 40 mm Hg and then the mixture is gradually heated up to 220°C to distill off the water and unreacted monomers from the reaction mixture.

Example 2

Synthesis of Novolak Resin

Following the same method as in Example 1, another novolak resin is synthesized with 47.13 mol% m-cresol, 42.83 mol% p-cresol, 2.66 mol% of 2,4-xylenol, 2.22 mol% of 2,5-xylenol, 2.14 mol% of 2,6-xylenol, 2.72 mol% of o-ethylphenol, and 0.22 mol% of other phenolic components. The resulting novolak resin has a weight average molecular weight of 10,000.

Example 3

Synthesis of Novolak Resin

A novolak resin with a weight average molecular weight 10,000 is synthesized from 60 : 40 (% by weight) m-cresol : p-cresol and formaldehyde by the same method as Example 1.

## Example 4

Synthesis of Photosensitive Substance

As the photosensitive material, an ester of 2,3,4,4'-tetrahydroxybenzophenone in which, on average, 3.2-3.95 hydroxy groups have been esterified by 1,2-naphthoquinone diazide-5-sulfonic acid, preferably 3.5-3.95 hydroxy groups have been so esterified, is used.

The photosensitive material may be synthesized by known techniques in which 2,3,4,4'-tetrahydroxybenzophenone is reacted with a defined amount of 1,2-naphthoquinone diazide-5-sulfonyl chloride in a solvent such as dioxane or acetone in the presence of a base such as triethylamine. See for example, U.S. Patent 4,719, 167, Example 2.

## Example 5

Preparation and Evaluation of Positive Photoresist Composition

(A) 3.6 g of the novolak resin synthesized in Example 2 and 0.73 g of the light sensitive ester of 2,3,4,4'-tetrahydroxybenzophenone in which on the average 3.8 hydroxy groups have been esterified by 1,2-naphthoquinone diazide-5-sulfonic acid synthesized in (4) is dissolved in 10 ml of propylene glycol methyl ether acetate (PGMEA). The solution is filtered through an 0.2 micron microfilter (made by Millipore) to prepare a photoresist formulation.

This photoresist composition is coated on a silicon wafer at a thickness of 1.2 micron using a spinner at 4000 rpm. The coated wafer is soft baked at 80°C on a hot plate for 45 seconds to remove solvents and is exposed to 436 nm light by a reduction step-and-repeat system having a 0.38 NA lens (made by ASET Corporation). The exposed wafer is baked on a hot plate at 105°C for 45 seconds and is developed for 60 seconds at 25°C in a 0.245 N tetramethyl-ammonium hydroxide developer (AZ 425 MIF).

The resolution and other properties of the specific formulation prepared in the Example are shown in Table 1.

(B) 3.6 of the novolak resin obtained in Example 2 and 0.73 g of the photosensitive ester obtained in Example 4 in which on the average 3.65 hydroxy groups have been esterified are dissolved in 9.7 g PGMEA and the solution filtered through 0.2 micron microfilter to prepare a photoresist composition.

This formulation is evaluated by the same procedure as in Example 5 and the results are given in Table I.

(C) 3.6 g of the novolak resin obtained in Example 2 and 0.73 g of the photosensitive ester obtained in Example 4 in which on the average 3.95 hydroxy groups have been esterified are dissolved in 9.7 g of PGMEA and the solution filtered through a 0.2 micron microfilter to prepare the photoresist composition.

This formulation is evaluated by the same procedure as in Example 5 and the results are given in Table I.

## Example 6

Comparative Examples :

(A) 22 wt.% of novolak resin obtained in Example 1 and 4 wt.% of photosensitive compound obtained in Example 4 in which on the average 3.8 hydroxy groups are esterified are dissolved in 74 wt.% PGMEA and filtered through a 0.2 micron microliter to prepare a photoresist composition.

This photoresist composition is spun on a silicon wafer at a thickness of 1.2 micron, soft baked at 80°C for 45 sec. to remove solvents and exposed to 436 nm by using the same exposure tool as in Example 5.

The exposed wafer is developed for 30 seconds at 25°C by a 0.22 N tetramethyl-ammonium hydroxide developer. The results are given in Table 1.

(B) 22 wt.% of novolak resin obtained in Example 1 and 4 wt.% of photosensitive compound obtained in Example 4 in which on the average 3.65 hydroxy groups are esterified is dissolved in 74 wt.% propylene glycol monomethyl ether acetate (PGMEA) and filtered through a 0.2 micron microfilter to prepare a photoresist composition.

This photoresist composition is evaluated as in Example 6 (A). The results are given in Table I.

(C) 22 wt.% of novolak resin obtained in Example 1 and 4 wt.% of photosensitive compound obtained in Example 4 in which on the average 3.95 hydroxy groups are esterified is dissolved in 74 wt.% PGMEA and filtered through a 0.2 micron microfilter to prepare a photoresist composition.

This photoresist composition is evaluated as in Example 6 (A), however, with an increased developer time to 45 seconds instead of 30 seconds. The results are given in Table I.

(D) 22 wt.% of novolak resin obtained in Example 3 and 4 wt.% of photosensitive compound obtained in Example 4 in which on the average 3.8 hydroxy groups are esterified is dissolved in PGMEA, filtered through a 0.2 micron microfilter to prepare a photoresist composition which is evaluated as in Example 6 (C). The results are given in Table I.

(E) 0.24 g of novolak resin obtained from Example 2 and 0.08 g of an ester of 2,3,4-trihydroxy benzophenone in which on the average 1.23 hydroxy groups are esterified by 1,2-naphthoquinonediazide-5-sulfonic acid is dissolved into 0.7 g of PGMEA. The solution is filtered through a 0.2 micron microfilter to prepare the photoresist which is spun on a silicon wafer to 4000 rpm to a thickness of 1.2 micron, soft baked at 100°C for 45 seconds, exposed to 436 nm light. The exposed wafer is baked for 30 minutes at 120°C in a convection oven and developed with 0.25 N tetramethyl-ammonium hydroxide, AZ 312 MIF (1 : 1) developer for 60 seconds at 25°C. The results are given in Table I.

## TABLE I

| Sample | Resolution (um) | Photosensitivity (ms)[1] | Dark Film Loss (um)[2] |
|--------|-----------------|--------------------------|------------------------|
| 5A | 0.7 | 300 | 0.04 |
| 5B | 0.7 | 226 | 0.032 |
| 5C | 0.7 | 430 | 0.034 |
| 6A | 0.9-1.0 | 160 | 0.06 |
| 6B | 0.9-1.0 | 220 | 0.05 |
| 6C | 0.9-1.0 | 260 | 0.08 |
| 6D | 1.1-1.2 | 160 | 0.08 |
| 6E | 1.0 | 300 | 0.05 |

1. The minimum exposure dose of actinic radiation as measured in milliseconds necessary to reproduce a mask pattern on to the photoresist coated substrate.

2. Film loss incurred in the unexposed area after processing.

## Claims

1. A positive photoresist composition consisting essentially of an admixture of
   (a) a photosensitive component comprising an ester of 2,3,4,4'-tetrahydroxybenzophenone, having on the average, from about 60 mol percent to about 100 mol percent of the hydroxy groups of the 2,3,4,4'-tetrahydroxybenzophenone having been esterified by 1,2-naphthoquinonediazide-5-sulfonic acid, said photosensitive component being present in the photoresist composition in an amount sufficient to uniformly photosensitize the photoresist composition ; and
   (b) a water insoluble, aqueous alkali soluble novolak resin obtained by condensing with formaldehyde a mixture of from about 2.0 to about 5.0 mol percent of 2,4-xylenol, from about 1.5 to about 4.5 mol percent of 2,5-xylenol, from about 1.5 to about 4.0 mol percent of 2,6-xylenol, from about 2.0 to about 5.0 mol percent o-ethylphenol, and the balance m-cresol and p-cresol in a respective mol ratio of from about 0.5 to about 2.0 to 1 ; said novolak resin being present in the photoresist composition in an amount sufficient to form a substantially uniform photoresist composition.

2. The composition of claim 1 wherein the novolak resin is obtained by condensing with formaldehyde a mixture of from about 2.8 to about 4.0 mol percent of 2,4-xylenol, from about 2.3 to about 3.3 mol percent of 2,5 xylenol, from about 2.1 to about 3.0 mol percent of 2,6 xylenol, from about 2.8 to about 4.0 mol percent o-ethylphenol, and the balance m-cresol and p-cresol in a respective mol ratio of from about 0.8 to about 1.5 to 1, wherein the resin has an average molecular weight in the range of from about 6,000 to about 14,000.

3. The composition of claim 1 or 2 wherein (a) is present in a weight percent of from about 1 to about 35 weight percent and (b) is present in a weight percent of from about 65 to about 99 weight percent based on the non-solvent parts of the composition.

4. The composition of any of claims 1-3 further comprising a solvent.

5. The compositon of claim 4 comprising one or more solvents selected from the group consisting of xylene, butyl acetate, ethylene glycol monoethyl ether acetate, propylene glycol mono-alkyl ether acetate, propylene glycol mono-alkyl ether, and mixtures thereof.

6. The composition of any of claims 1-5 further comprising one or more additives selected from the group consisting of colorants, leveling agents, anti-striation agents, plasticizers, adhesion promoters, speed enhancers, and surfactants.

7. The composition of any of claims 1-6 wherein the photosensitive component has about 100 mol percent of the hydroxy groups of the 2,3,4,4' -tetrahydroxybenzophenone having been esterified by 1,2-naphthoquinonediazide-5-sulfonic acid.

8. A photosensitive element which comprises a substrate and the dried composition of any of claims 1-7 coated on said substrate.

9. The element of claim 8 wherein the substrate is selected from the group consisting of silicon, aluminum, polymeric resins, silicon dioxide, doped silicon dioxide, gallium arsenide, Group III/V compounds, silicon nitride, tantalum, copper, polysilicon, ceramics and aluminum/copper mixtures.

10. The element of claim 8 or 9 wherein the substrate has an adhesion promoted surface.

11. A method for producing a photoresist image on a substrate, which comprises coating a substrate with the positive working photosensitive composition of claim 4 or any of claims 5-7 as dependant on claim 4 ; heat treating said coated substrate until substantially all of the solvent is removed ; imagewise exposing said photosensitive composition to actinic radiation ; and removing the imagewise exposed areas of said composition with an aqueous alkaline developer.

12. The method of claim 11 further comprising heating said coated substrate at a temperature of from about 90°C to about 150°C for from about 30 seconds to about 180 seconds on a hot plate or for from about 15 minutes to about 40 minutes in an oven after the exposure step but before the removing step.

13. The method of claim 11 further comprising heating said coated substrate at a temperature of from about 90°C to about 150°C for from about 30 seconds to about 180 seconds on a hot plate or for from about 15 minutes to about 40 minutes in an oven after the removing step.

14. The method of any of claims 11-13 wherein the exposure step is conducted with actinic, x-ray or ion beam radiation.

15. The method of any of claims 11-13 wherein the exposure step is conducted with ultraviolet radiation having a wavelength of from about 300 nm to about 450 nm.

16. The method of any of claims 11-15 wherein the developing step is conducted with sodium hydroxide, potassium hydroxide or tetramethyl ammonium hydroxide.

17. The method of any of claims 11-16 wherein said substrate comprises one or more components selected from the group consisting of silicon, aluminum, polymeric resins, silicon dioxide, doped silicon dioxide, silicon nitride, tantalum, copper, polysilicon, ceramics, aluminum/copper mixtures, gallium arsenide and Group III/V compounds.

18. A method for producing a photoresist composition which comprises
   (a) preparing a photosensitive component by esterifying 2,3,4,4' -tetrahydroxybenzophenone with 1,2-naphthoquinonediazide-5-sulfonic acid such that on the average, from about 60 mol percent to about 100 mol percent of the hydroxy groups of the 2,3,4,4' -tetrahydroxybenzophenone are esterified with the 1,2-naphthoquinonediazide-5-sulfonic acid ; and
   (b) preparing a novolak resin by condensing with formaldehyde a mixture of from about 2.0 to about 5.0 mol percent of 2,4-xylenol, from about 1.5 to about 4.5 mol percent of 2,5-xylenol, from about 1.5 to about 4.0 mol percent 2,6-xylenol, from about 2.0 to about 5.0 mol percent of 0-ethylphenol, and the balance m-cresol and p-cresol in a respective mol ratio of from about 0.5 to about 2.0 to 1 ; and
   (c) affixing said photosensitive component, said novolak resin and a solvent composition, the photosensitive component being present in the photoresist composition in an amount sufficient to uniformly photosensitize the photoresist composition ; said novolak resin and solvent composition being present in the photoresist composition in an amount sufficient to form a substantially uniform photoresist composition.

19. The method of claim 18 wherein there is employed the feature of any of claims 2, 4, 5, 6 or 7.